# EUROPEAN PATENT APPLICATION

(11) **EP 0 822 417 A2**
(43) Date of publication of application: **04.02.1998**
(21) Application number: 97113194.1
(22) Date of filing: 31.07.1997
(51) Int. Cl.: G01R 31/06

(54) **Probe positioning assembly for armature tester**

(30) Priority: 01.08.1996 US 23524; 07.07.1997 US 889209
(71) Applicant: AXIS S.p.A., I-50028 Tavarnelle Val di Pesa (Firenze) (IT)
(72) Inventor: Galassi, Rossano, 50125 Firenze (IT); Manuelli, Giovanni, 50137 Firenze (IT)
(74) Representative: Lotti, Giorgio

(57) **Abstract**

A probe positioning assembly for an armature tester has a plurality of electrical probes corresponding to the number of commutator bars in the armature to be tested. The probes are mounted on insulating blocks that are connected by spring arms to an insulating ring. In their neutral positions, the probes define a circular opening into which the armature can enter with clearance between the probes and the commutator. An actuator in contact with each support block also contacts at its other end a flexible membrane defining one wall of a hollow annular chamber surrounding the assembly. After the armature is in position with the commutator bars adjacent the probes, the hollow chamber is pressurized, causing the membrane to uniformly and simultaneously push on each actuator, so that each support block and the probes carried thereby move uniformly and simultaneously toward the commutator, until the probes touch the commutator bars. Testing can then be carried out, after which the hollow chamber is depressurized, allowing the support blocks and their probes to return to the neutral position under the influence of the spring arms. By providing a socket in the test station for receiving the assembly, one can provide a system that can test armatures of different sizes by inserting different sized assemblies in the socket.

## Description

### Background of the Invention

This invention relates to apparatus for testing the electrical characteristics of armatures at the final stage of their manufacturing process, just prior to assembly of the armature into a finished electric motor or other dynamoelectric machine. More particularly, this invention relates to an assembly in such testing apparatus, which assembly is used to position electrical probes relative to the commutator of the armature.

It is known to provide, at a station located along an automatic armature manufacturing line, testing apparatus with which the armature manufacturer can obtain measurements of, and reports on, the electrical characteristics of the armatures being produced. Such characteristics include those referred to in the electric motor manufacturing field as neutral zone measurements, fusing resistance measurements, coil resistance measurements and surge measurements.

Examples of previously known testing apparatus of this type are shown in commonly-assigned United States Patents Nos. 4,651,086, 5,526,977 and 5,396,179. In such apparatus, to measure the electrical characteristics of interest, probes are placed into contact with the individual bars of the commutator of the armature in order to inject a testing current into the coils of the armature and to pick up consequent voltage and current measurement signals which are generated. Usually, two probes are applied to each commutator bar; one injects the current while the other is used as a pickup for voltage and current measurement signals.

Prior to the development of automatic testing equipment, a statistical sampling of armatures was removed from the manufacturing line for manual testing, and the test results were extrapolated to the remaining armatures. With the advent of automatic testing apparatus, it became possible to test each armature, rather than to rely on a statistical sampling. However, in order to test every armature, the test of each individual armature must take place over an extremely short time period. Moreover, because of the small dimensions involved -- commutator bars are only a few millimeters wide, and the entire commutator is only a few centimeters across -- great precision is also required, so that accurate, rapid and stable application of the probes to the commutator bars, to form a good electrical contact, can be achieved. In addition, different armatures may have commutators of different dimensions, so that even if the testing apparatus is properly aligned and dimensioned for a particular size of armature, it would have to be realigned and readjusted for other armatures.

In one known automatic testing apparatus, test probes (corresponding in number to the number of commutator bars to be tested) in the form of pins are mounted for radial movement in an insulating annular ring. Each test probe is spring biased outward, and is urged inward toward a commutator to be tested by its own individual pneumatic cylinder. When the size or configuration of the commutator to be tested changes, a different ring with a different number or configuration of probes can be substituted. This requires a complex and expensive arrangement of pneumatic cylinders and air supply hoses. Moreover, the test probes are in the form of needles with somewhat rounded points, and can leave indentations in the commutator bars that may interfere with contact between the commutator bars and the brushes during operation of the finished dynamoelectric machine.

It would be desirable to be able to provide a test probe positioning apparatus that can quickly and accurately apply test probes to the commutator of an armature.

It would also be desirable to be able to provide a test probe positioning system that can accommodate armatures of different sizes.

It would further be desirable to be able to provide a test probe positioning apparatus that minimizes damage to the commutator being tested.

### Summary of the Invention

It is an object of this invention to provide a test probe positioning apparatus that can quickly and accurately apply test probes to the commutator of an armature.

It is also an object of this invention to provide a test probe positioning system that can accommodate armatures of different sizes.

It is a further object of this invention to provide a test probe positioning apparatus that minimizes damage to the commutator being tested.

In accordance with this invention, there is provided a probe positioning assembly for use in a testing station for testing electrical characteristics of armatures having commutators including a plurality commutator bars, each of the commutators having a commutator diameter. The assembly, which positions electrical probes in contact with said commutator bars, includes an insulating ring having a center hole therethrough, the center hole having a hole diameter exceeding the commutator diameter. A plurality of electrical probes is positioned within the center hole, the plurality of electrical probes at least corresponding to the plurality of commutator bars. The electrical probes are movable between (a) a first position in which they form an opening for receiving the commutator therein, the opening having a center and an opening diameter greater than the commutator diameter, and (b) a second position radially closer to the center. The electrical probes are biased toward the first position. A plurality of actuators is mounted on the ring for radial movement. The actuators are biased radially outwardly and are aligned with the electrical probes. An actuator moving mechanism moves the actuators radially inwardly toward the electrical probes. When the armature is positioned with the commutator in the opening with clearance between the commutator bars and the electrical probes, and the actuator moving mechanism urges the actuators radially inwardly toward the electrical probes, the actuators push the electrical probes radially inwardly, forcing the electrical probes into engagement with the commutator bars. When the actuator moving mechanism stops urging the actuators radially inwardly, the actuators move radially outwardly under the radially outward bias and the electrical probes return to the first position toward which they are biased.

A probe positioning system including at least one such probe positioning assembly, which can be removably inserted in a socket of a test station, is also provided.

### Brief Description of the Drawings

The above and other objects and advantages of the invention will be apparent upon consideration of the following detailed description, taken in conjunction with the accompanying drawings, in which like reference characters refer to like parts throughout, and in which:
FIG. 1 is a partial cross-sectional view of a preferred embodiment of a probe positioning assembly according to the present invention, with an armature (in fragmentary elevation) in position for engagement with the electrical probes;
FIG. 2 is an enlarged cross sectional view, similar to a portion of FIG. 1, showing the electrical probes in contact with a commutator bar; and
FIG. 3 is an elevational view, taken from line 3-3 of FIG. 2 (with actuating pin 19 omitted), showing a portion of the commutator with the electrical probes in contact with the commutator bar.

### Detailed Description of the Invention

The probe positioning assembly of the present invention brings the electrical probes substantially simultaneously into contact with all the commutator bars of a particular commutator to be tested. The probe positioning assembly preferably has a respective pair of probes for each commutator bar, although there can be some other correspondence between the number of commutator bars and the number of probes. An actuation system preferably moves each pair of probes simultaneously and uniformly toward the commutator bars.

In a probe positioning system according to the present invention, a plurality of probe positioning assemblies is provided, with at least one probe positioning assembly being provided for each type or size of armature expected to be encountered. A probe positioning assembly that corresponds in size and configuration to the armature to be tested can be inserted into a socket in a testing apparatus. The socket is preferably aligned with an armature holder so that the armature can be properly aligned relative to the probe positioning assembly. The socket also has electrical connectors to connect the electrical probes of the different probe positioning assemblies to the test equipment that provides the testing signals and analyzes the resulting measurement signals.

The probe positioning assemblies and system according to the invention preferably are used in a test station which preferably is part of an armature manufacturing line. Each armature is transferred by a load/unload device from a transportation mechanism (e.g., a conveyor) of the manufacturing line to the test station. The load/unload device preferably functions as the armature holder referred to above, which preferably is aligned, in its loaded position, with the probe positioning assembly.

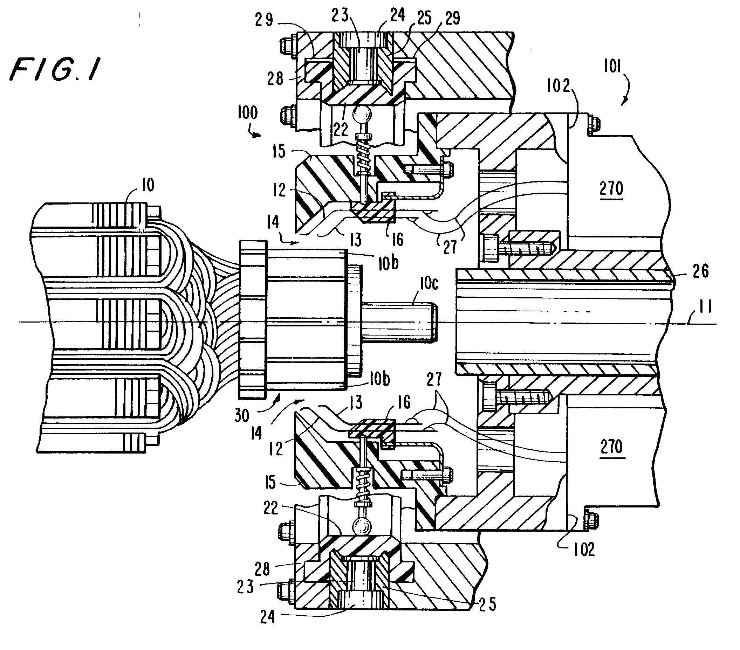

The invention is best described with reference to FIGS. 1-3.

As seen in FIG. 1, an armature 10 to be tested preferably is positioned with respect to the probe positioning assembly 100 by a holding device (not shown) which holds it in a holding portion (also not shown). At least a portion of the testing apparatus 101, including probe positioning assembly 100, then preferably moves parallel to axis 11 toward armature 10 until it reaches a position in which probes 12, 13 are aligned with commutator bars 10b. This position can be defined by a stop (not shown) or any other suitable means, which may be conventional. In the position shown in FIG. 1, the stop has been reached, giving rise to alignment between each pair of probes 12, 13 and the respective commutator bar 10b which probes 12, 13 must contact during the test. Alternatively, the holding device itself, and therefore armature 10, move parallel to axis 11 until the alignment position, preferably defined by a stop (not shown), is reached.

Probes 12, 13 preferably are affixed to an annular ring 15 by a structure which will be more fully described below. The number of pairs of probes 12, 13 affixed to annular ring 15 preferably is equal to the number of commutator bars 10b in the commutator 30. The pairs of probes 12, 13 preferably are affixed substantially equiangularly to annular ring 15 such that each pair of probes 12, 13 is aligned with a respective commutator bar 10b when the stop condition of FIG. 1 is reached.

During the loading operation preceding the stop condition (shown in FIG. 1), clearance 14 exists between probes 12, 13 and the commutator bars 10b to prevent contact between them.

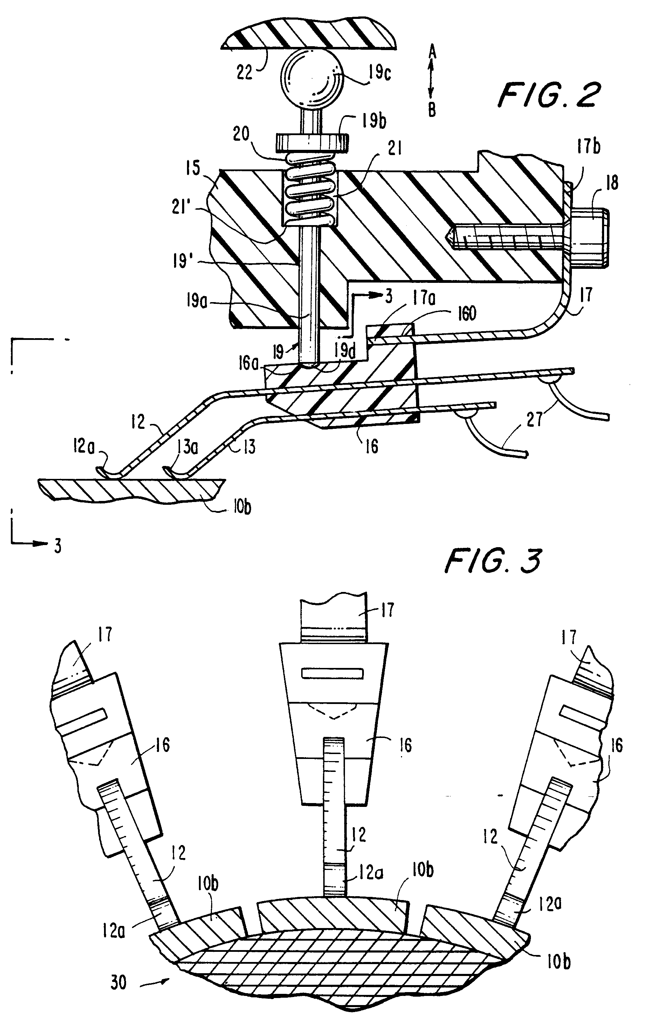

As best seen in FIGS. 2 and 3, in which probes 12, 13 are shown in contact with their respective commutator bar 10b for carrying out the desired testing measurements, probes 12, 13 preferably have the form of elongated fingers, which preferably are held in a support block 16. The portion 12a, 13a of each finger 12, 13 in contact with its respective commutator bar 10b preferably is curved to avoid a sharp contact zone (which might undesirably increase contact resistance) and to provide sufficient rigidity to preferably remain undeformed under the contact forces generated during the test operations.

As seen in FIG. 3, fingers 12, 13 and support blocks 16 are positioned around commutator 30. FIG. 3 also shows how adjacent pairs of probes 12, 13 are positioned with respect to each other and in contact with their respective commutator bars 10b.

Support block 16 preferably is attached to annular ring 15 by means of spring am 17, which preferably is curved. Spring arm 17 preferably has one end 17a force fit into a seat 160 in support block 16, while another end 17b preferably has a bore through which a fastening bolt 18 passes and is screwed into annular ring 15. This provides a stable connection, through spring arm 17, of support block 16, and probes 12, 13, to annular ring 15.

Beyond each support block 16, and along a radius passing through the center of commutator 30, there preferably is a respective actuating pin 19 which preferably runs in a bore 19' in annular ring 15. Each bore 19' is preferably in alignment relative to each probe 12, 13 for moving the probe 12, 13 directly or, preferably, indirectly as described below. The pin preferably can move either radially away from commutator 30 in the direction shown by arrow A or radially toward commutator 30 in direction shown by arrow B. Pin 19 preferably is provided with an elongated cylindrical portion 19a which preferably is guided in bore 19' of annular ring 15 during movements in directions A, B. Shoulder 19b of pin 19 preferably provides an abutment face for an upper end of a spring 20, while a lower end of spring 20 preferably abuts against a face 21' of a cylindrical seat 21 preferably machined in annular ring 15 in substantially coaxial alignment with bore 19'. Pin 19 preferably is also provided with an enlarged spherical portion 19c at its radially outward end and a rounded tip 19d at its radially inward end.

Support block 16 preferably is positioned in alignment with bore 19' of annular ring 15 so that rounded tip 19d of pin 19 is in alignment with, and can engage, recess 16a in support block 16. Enlarged spherical portion 19c at the other end of pin 19 preferably engages annular flexible membrane 22. Membrane 22, which preferably forms one wall of an annular chamber 23, preferably is captured in appropriate seats 29 by flange disk 28, to form an airtight seal. Chamber 23 preferably can be supplied with pressurized fluid, preferably air, through inlet ports 24. When chamber 23 is supplied with pressurized air or other fluid, membrane 22 preferably expands and pushes on enlarged portion 19c to move pin 19 in direction B towards the commutator, against the action of spring 20. This action of membrane 22 preferably acts substantially uniformly and substantially simultaneously on each pin 19. Movement of each respective pin 19 preferably causes each support block 16 to move from the position shown in FIG. 1 towards commutator 30 to indirectly move each pair of probes 12, 13 into contact with its respective commutator bar 10b as shown in FIGS. 2 and 3, so that the desired testing can be carried out to obtain the desired measurements.

When support block 16 is moved, as has been described, spring arm 17 preferably bends and as a result of its elasticity preferably exerts a restoring force on support block 16, tending to return support block 16 to the position shown in FIG. 1 where probes 12, 13 are no longer in contact with commutator bars 10b. Therefore to end contact between probes 12, 13 and commutator bars 10b after testing, chamber 23 preferably is depressurized so that the restoring force of spring arm 17 can prevail and return support block 16 to the position shown in FIG. 1. In particular, the restoring force of spring arm 17 preferably brings probes 12, 13 to the position shown in FIG. 1 with predetermined clearance 14 between probes 12, 13 and commutator bars 10b. When chamber 23 is depressurized, support block 16, under the action of the restoring force, preferably pushes on pin 19 and helps it to move in direction A away from the commutator. At the same time, the release of spring 20, which had been compressed by the movement of pin 19 in direction B towards the commutator, preferably also helps pin 19 move in direction A away from commutator 30, thus avoiding any impediment to the return movement of support block 16.

Annular ring 15 and member 25, delimiting chamber 23, are fixed to a frame structure (not shown) which is part of the equipment, which is preferably conventional, of the testing station. Tube 26, also connected to the frame structure, preferably is hollow to receive, and therefore allow clearance for, armatures having long shafts that may extend along axis 11 beyond the position of shaft 10c shown in FIG. 1.

Each of probes 12, 13 preferably is connected at test socket 102 by a respective electric cable 27 to a connection box 270 for allowing passage of the injected current or for transferring the measurement signals. Cables 27 preferably are soldered to the end of the probes as shown in FIGS. 1 and 2.

Probes 12, 13 preferably are made of copper containing a small amount of beryllium. Contact portions 12a, 13a preferably are silvered to improve their electrical contact with commutator bars 10b. Spring arm 17 preferably is made of a spring steel to provide the elasticity required for the restoring force described above. Support block 16 preferably is made of insulating material like plastic. Annular ring 15 also is preferably made of such a material. One suitable insulating plastic material is that sold by E.I. Du Pont de Nemours and Company, of Wilmington, Delaware, under the trademark DELRIN®.

In a system according to the invention for testing armatures having different sizes, a plurality of positioning assemblies 100 according to the invention, also of different sizes, can be provided. Each assembly 100 in such a system would be removably received in socket 102 at testing station 101 having both mechanical and electrical connections for the assembly 100. The correctly sized assembly 100 for the particular size of armature 10 being manufactured during a particular run would be inserted in socket 102 for the duration of that run.

Thus it is seen that a test probe positioning apparatus that can quickly and accurately apply test probes to the commutator of an armature, and a test probe positioning system that can accommodate armatures of different sizes, have been provided. One skilled in the art will appreciate that the present invention can be practiced by other than the described embodiments, which are presented for purposes of illustration and not of limitation, and the present invention is limited only by the claims which follow.

## Claims

1. A probe positioning assembly for use in a testing station for testing electrical characteristics of armatures having commutators including a plurality of commutator bars, for positioning electrical probes in contact with said commutator bars, each of said commutators having a commutator diameter, said assembly comprising:
an insulating ring having a center hole therethrough, said center hole having a hole diameter exceeding said commutator diameter;
a plurality of electrical probes positioned within said center hole, said plurality of electrical probes at least corresponding to said plurality of commutator bars, said electrical probes being movable between (a) a first position in which they form an opening for receiving said commutator therein, said opening having a center and an opening diameter greater than said commutator diameter, and (b) a second position radially closer to said center, said electrical probes being biased toward said first position;
a plurality of actuators mounted on said ring for radial movement, said actuators being biased radially outwardly and being aligned with said electrical probes; and
an actuator moving mechanism for moving said actuators radially inwardly toward said electrical probes; wherein:
when said armature is positioned with said commutator in said opening with clearance between said commutator bars and said electrical probes and said actuator moving mechanism urges said actuators radially inwardly toward said electrical probes, said actuators push said electrical probes radially inwardly, forcing said electrical probes into engagement with said commutator bars; and
when said actuator moving mechanism stops urging said actuators radially inwardly, said actuators move radially outwardly under said radially outward bias and said electrical probes return to said first position toward which they are biased.

2. The probe positioning assembly of claim 1 wherein:
said insulating ring has a plurality of substantially radial bores therein; and
each of said actuators is received in one of said bores for radial movement.

3. The probe positioning assembly of claim 2 wherein said actuators are biased radially outwardly.

4. The probe positioning assembly of claim 1 further comprising a plurality of insulating support blocks positioned within said center hole, said plurality of support blocks corresponding to said plurality of commutator bars, at least one of said electrical probes depending from each of said support blocks, each of said actuators being aligned with one of said support blocks.

5. The probe positioning assembly of claim 4 further comprising a plurality of deformable support arms, each of said deformable support arms attaching one of said plurality of support blocks to said insulating ring in a rest position, said deformable support arms being deformable out of said rest position and being biased to return to said rest position.

6. The probe positioning assembly of claim 5 wherein:
each of said actuators has a radially outward end; and
said actuator moving mechanism comprises:
a chamber having a flexible wall facing said center, and
a source of fluid under pressure communicating with said chamber; and
said radially outward end of each of said actuators is adjacent said flexible wall; whereby:
when fluid under pressure is introduced into said chamber, said flexible wall moves radially inward toward said center, urging said radially outward ends of said actuators radially inward, said actuators pushing said support blocks radially inwardly, deforming said support arms, and forcing said electrical probes into engagement with said commutator bars.

7. The probe positioning assembly of claim 6 wherein said flexible wall comprises a membrane.

8. The probe positioning assembly of claim 7 wherein said membrane is elastomeric.

9. The probe positioning assembly of claim 6 wherein said source of fluid under pressure comprises a source of compressed air.

10. The probe positioning assembly of claim 1 wherein each of said electrical probes comprises copper and beryllium.

11. The probe positioning assembly of claim 1 wherein each of said electrical probes comprises a silvered contact portion.

12. A probe positioning system for use in a testing station for testing electrical characteristics of armatures having commutators including a plurality of commutator bars, for positioning electrical probes in contact with said commutator bars, each of said commutators having a commutator diameter, said commutator diameter varying among said commutators, said system comprising:
a socket in said testing station for receiving a probe positioning assembly; and
at least one probe positioning assembly, each said at least one probe positioning assembly having an assembly diameter corresponding to a respective diameter of one of said commutators, each said assembly comprising:
an insulating ring having a center hole therethrough, said center hole having a hole diameter exceeding said respective commutator diameter,
a plurality of electrical probes positioned within said center hole, said plurality of electrical probes at least corresponding to said plurality of commutator bars, said electrical probes being movable between (a) a first position in which they form an opening for receiving said commutator therein, said opening having a center and an opening diameter greater than said commutator diameter, said opening diameter being said assembly diameter, and (b) a second position radially closer to said center, said electrical probes being biased toward said first position,
a plurality of actuators mounted on said ring for radial movement, said actuators being biased radially outwardly and being aligned with said electrical probes, and
an actuator moving mechanism for moving said actuators radially inwardly toward said electrical probes, wherein:
when said armature is positioned with said commutator in said opening with clearance between said commutator bars and said electrical probes and said actuator moving mechanism urges said actuators radially inwardly toward said electrical probes, said actuators push said electrical probes radially inwardly, forcing said electrical probes into engagement with said commutator bars, and
when said actuator moving mechanism stops urging said actuators radially inwardly, said actuators move radially outwardly under said radially outward bias and said electrical probes return to said first position toward which they are biased; wherein:
at any one time, one of said at least one probe positioning assembly, having an assembly diameter corresponding to a diameter of a commutator to be tested, is in said socket.

13. The probe positioning system of claim 12 wherein:
said insulating ring has a plurality of substantially radial bores therein; and
each of said actuators is received in one of said bores for radial movement.

14. The probe positioning system of claim 13 wherein said actuators are biased radially outwardly.

15. The probe positioning system of claim 12 further comprising a plurality of insulating support blocks positioned within said center hole, said plurality of support blocks corresponding to said plurality of commutator bars, at least one of said electrical probes depending from each of said support blocks, each of said actuators being aligned with one of said support blocks.

16. The probe positioning system of claim 15 further comprising a plurality of deformable support arms, each of said deformable support arms attaching one of said plurality of support blocks to said insulating ring in a rest position, said deformable support arms being deformable out of said rest position and being biased to return to said rest position.

17. The probe positioning system of claim 16 wherein:
each of said actuators has a radially outward end; and
said actuator moving mechanism comprises:
a chamber having a flexible wall facing said center, and
a source of fluid under pressure communicating with said chamber; and
said radially outward end of each of said actuators is adjacent said flexible wall; whereby:
when fluid under pressure is introduced into said chamber, said flexible wall moves radially inward toward said center, urging said radially outward ends of said actuators radially inward, said actuators pushing said support blocks radially inwardly, deforming said support arms, and forcing said electrical probes into engagement with said commutator bars.

18. The probe positioning system of claim 17 wherein said flexible wall comprises a membrane.

19. The probe positioning system of claim 18 wherein said membrane is elastomeric.

20. The probe positioning system of claim 17 wherein said source of fluid under pressure comprises a source of compressed air.

21. The probe positioning system of claim 12 wherein each of said electrical probes comprises copper and beryllium.

22. The probe positioning system of claim 12 wherein each of said electrical probes comprises a silvered contact portion.
